# EUROPEAN PATENT SPECIFICATION

(11) **EP 3 076 756 B1**
(45) Date of publication and mention of the grant of the patent: **21.07.2021**
(21) Application number: 15161664.6
(22) Date of filing: 30.03.2015
(51) Int. Cl.: H05B 45/10, H05B 45/14

(54) **OLED DEVICE AND DRIVING METHOD**
OLED-VORRICHTUNG UND ANSTEUERUNGSVERFAHREN
DISPOSITIF À DELO ET PROCÉDÉ DE COMMANDE

(43) Date of publication of application: 05.10.2016
(73) Proprietor: OLEDWorks GmbH, 52068 Aachen (DE)
(72) Inventor: HENTE, Dirk, 52146 Würselen (DE); RADERMACHER, Harald Josef Günther, 52080 Aachen (DE)
(74) Representative: Gunzelmann, Rainer

(56) References cited:
- WO-A1-2009/057041
- WO-A1-2010/029459
- WO-A1-2010/092504
- WO-A2-02/19775
- DE-A1-102013 109 814
- US-A- 4 766 471
- US-A1- 2007 029 939
- US-A1- 2010 123 409

## Description

### FIELD OF THE INVENTION

This invention relates to OLEDs which encode information about their electrical characteristics, which may be taken into account when driving the OLED.

### BACKGROUND OF THE INVENTION

It is known that it is desirable for an LED driver to be able to recognise the type of LED to which it is connected, and that an LED device can be arranged to provide information about its characteristics to enable a driver to be controlled accordingly.

In this description and claims, the general term "LED" will be used to denote both organic and inorganic LEDs, and the invention can be applied to both categories. The detailed examples below are based on OLEDs as the invention is of particular interest to devices with a light emitting layer which extends over an area.

LEDs are current driven lighting units. They are driven using an LED driver which delivers a desired current to the LED.

The required current to be supplied varies for different lighting units, and for different configurations of lighting unit. The latest LED drivers are designed to have sufficient flexibility that they can be used for a wide range of different lighting units, and for a range of numbers of lighting units.

To enable this flexibility, it is known for the driver to operate within a so-called "operating window". An operating window defines a relationship between the output voltage and output current that can be delivered by the driver. Providing the requirements of a particular lighting load fall within this operating window, the driver is able to be configured for use with that particular lighting load, giving the desired driver flexibility.

The driver has its output current set to the desired level within its operating window.

Different types of LED (with different shape, colour, size, organics or brightness) require different electrical driving parameters such as current and voltage. Several proposals have been made to encode the type of the LED into its structure, which can be read out using dedicated detector terminals (either wired sockets or capacitively coupled pads). This enables the driver to be programmed to deliver a specific current.

A much simpler way is to use resistors (or other components) to encode the type of the OLED or the required driving current. In this way, a current setting resistor or other component, outside the driver, is read by the driver. The value of the current setting resistor or other component is measured by the driver, which can then configure its output accordingly, so that the output current is determined by the resistance value. The important point is that after the driver has been produced, the output current can be selected, so that a single driver design is suitable for a range of output currents.

Once the current has been set, the voltage delivered by the driver will vary depending on the load presented to it (since the LEDs are current driven), but the driver will maintain this voltage within the operating window.

There is a particular need for a flexible driver because OLED technology is quite new and developing fast. Times between innovation of new materials and OLED architectures to give improved performance data (lumen, brightness, efficiency, size, ...) are very short, for example compared to typical support periods for products using the OLEDs. This support period is typically in the range of multiple years. Driver electronics also develops quickly to keep up with the demands of the new devices, particularly as driver architectures from historical LED technology cannot be simply copied to support OLEDs as well.

Although lifetime and reliability of OLEDs is also continuously improving, failed products have to be replaced. The required performance of typical devices requires the implementation of multiple OLEDs per luminaire. There is a need to be able to exchange just one OLED within such a device, and to then use an updated OLED design. For example, it is desired not to produce old device architectures longer than required, so that all production time can be allocated to state of the art devices.

One way to support older OLEDs with newer drivers or drive newer OLEDs in applications equipped also with older devices is to provide a flexible driver which knows how to drive the OLED appropriately (reduced current, dedicated dimming levels, and any other OLED characteristics and settings) and this is enabled by the current setting resistor (or other component such as a capacitor) as mentioned above. These components can be provided on a PCB attached to the OLED.

A drawback of this approach is that everything added to the back of the OLED contributes to the overall thickness of the luminaire/module. It also requires additional pick and place steps as well as solder steps to apply the resistor (or any other component) to a PCB.

In addition to that, to be able to encode a certain range of different currents, e.g. 100 mA ... 2 A, a certain variety of resistors has to be on stock and chosen accordingly.

There is therefore a need for a way to encode OLED information directly into the device structure.

US 2007/029939 A1 concerns an electroluminescent sign and a method for selectively illuminating such an electroluminescent sign. The method includes steps of creating an electroluminescent sign having an electroluminescent region and a coded information region, the coded information region providing instructions to illuminate the electroluminescent region. The method further includes steps of reading the coded information region to obtain the instructions, and selectively illuminating the electroluminescent region according to the instructions provided by the coded information region.

US 4766471 A concerns an electro-optical communication device which includes a light transmissive conduit integrally formed to interconnect a light emitter and a light detector. The length over which the light transmissive conduit extends is substantially greater than the size of either the light emitter or the light detector. The light emitter and the light detector are each formed from amorphous semiconductor alloy material and may be substantially surrounded by the light transmissive conduit.

DE 10 2013 109 814 A1 concerns an optoelectronic component comprising a planar optically active structure and an electrical circuit structure. The planar optically active structure is formed for recording and/or providing electromagnetic radiation. The electrical circuit structure is adapted to provide an output value, the output value being dependent upon at least one operating parameter of the optically active structure.

US 2010/123409 A1 concerns a light-emitting device including a first substrate with an energy transmission coil disposed thereover, a dielectric barrier layer embedding underneath the energy transmission coil, a sealant wall circling around the dielectric barrier layer, a second substrate disposed against the first substrate and supported by the sealant wall, and a high-frequency oscillating power supply connected to the energy transmission coil.

### SUMMARY OF THE INVENTION

The invention is defined by the claims. Some or all of the above problems are overcome by an OLED device according to claim 1, and/or a method of driving an OLED device according to claim 8. Further aspects of the present invention are defined in the dependent claims.

The following example is not within the scope of the invention. There is provided an LED device, comprising:
- a substrate;
- a stack of layers defining an LED component and including an electroluminescent layer;
- an encoding structure formed on top of the stack, wherein the area-dependent resistance or inductance of the encoding structure encodes information concerning the electrical characteristics of the LED component.

This device encodes relevant data concerning the electrical characteristics of the LED component and this may be achieved using existing layers of the LED component structure. By using the area-dependent inductance or resistance of the encoding layer to encode the LED electrical characteristics, the same design can simply be scaled to encode different information for different devices. In particular, the drive current required by an LED may scale with area so that a correspondingly scaled encoding layer area automatically encodes a suitably scaled LED drive current requirement.

Note that different types of encoding structure may be used in one design, so that there may be an encoding structure within the stack, and/or on top of the stack and/or around the stack.

By using a layer over or around the stack, no additional required area may be needed. For example, the LED device may include a PCB around the stack of layers so that even providing the encoding layer around the electroluminescent layer may not require any additional lateral space.

In a first example, which is not within the scope of the invention, the encoding layer comprises a resistive layer provided over the LED component, the resistive layer having an area which is a predetermined ratio of the LED component light output area.

The area of the resistive layer can be determined by measurement of the resistance of the layer (between contact electrodes). The resistive layer may be formed with the stack of layers of the LED component, thereby taking up no further lateral space around the LED component, and can also be implemented with very thin layers.

First and second electrodes may be used to probe the resistive layer. In one example, there may comprise electrode layers provided above and beneath the resistive layer respectively to enable probing of the resistance of the resistive layer.

The resistive layer and the first and second electrode layers may for example be provided over an LED component encapsulation layer, although they may be at other locations within the stack.

In one implementation, which is not within the scope of the invention, the resistive layer and the electrodes may have an area equal to the area of the LED component. However, the resistive layer may instead comprise a reference portion and a readout portion. The reference portion can be used to calibrate the resistance measurement of the readout portion. For example, the reference portion may have the same area for different sized LED devices, and the measurement is then a resistance measurement relative to the resistance of a fixed area reference portion of the resistive layer.

A set of LED devices of this type, which are not within the scope of the invention, may be provided, wherein each LED device has a different size electroluminescent layer, and wherein the area of the resistive layer (or the readout portion) of each LED device has the same proportion to the area of the electroluminescent layer.

In a second example, the encoding structure comprises an inductive loop. This loop may be formed by a cable around the stack, or it may be formed by layers on the substrate.

In one example, which is not within the scope of the invention, there is a PCB which connects to the LED component substrate, and the encoding layer comprises an electrode layer of the PCB in which an inductor loop or loops are formed, which electrode layer surrounds the stack of layers of the LED component, wherein the loop area is a predetermined ratio of the LED component light output area.

The area of the electrode layer can be determined by measurement of the inductance of the loop or loops. The size of the loop or loops influences the inductance.

In all examples, the encoding layer may encode information concerning a desired driving current and/or voltage and/or a required dimming level.

The following example is not within the scope of the invention. There is also provided an LED lighting apparatus comprising:
- a device as defined above, and which comprises a PCB which connects to the terminals of the LED component; and
- a driver comprising a connection part for interfacing with the PCB, wherein the driver comprises testing circuitry for determining an electrical characteristic of the encoding layer which is dependent on the area of the encoding layer.

The testing circuitry is thus part of the driver, so that the components which need to be carried by the PCB are kept to a minimum. The PCB acts as an interface between the driver and the substrate of the device. The PCB may carry no components at all and simply function as an interface.

The driver is then adapted to drive the LED device in dependence on the information concerning the characteristics of the LED component as determined by the testing circuitry.

There is also provided a method of driving an LED device, which is not within the scope of the invention, which comprises a substrate, a stack of layers defining an LED component and including an electroluminescent layer, and an encoding layer formed within, on top of, or around the stack of layers, wherein the area of the encoding layer encodes information concerning the electrical characteristics of the LED component, and the encoding layer overlies or surrounds the electroluminescent layer, the method comprising:
- measuring a resistance of the encoding layer which is dependent on the area of the encoding layer, which electrical characteristic encodes information concerning the electrical characteristics of the LED component; and
- driving the LED device using a driver which is controlled in dependence on the encoded information.

The measured electrical characteristic of the encoding layer may comprise a resistance, a capacitance to another layer, or an inductance.

### BRIEF DESCRIPTION OF THE DRAWINGS

Examples of the invention will now be described in detail with reference to the accompanying drawings, in which:
- Figure 1 shows an example of an OLED device;
- Figure 2 shows how a PCB can be mounted on the OLED device ledge;
- Figure 3 shows a first example in which a resistive layer is used to encode electrical characteristic information about the OLED device;
- Figure 4 shows a second example in which a resistive layer is used to encode electrical characteristic information about the OLED device;
- Figure 5 shows a first example of electrode layout used in the example of Figures 3 and 4;
- Figure 6 shows a first example of circuit for controlling the OLED in dependence on the resistance;
- Figure 7 shows a second example of circuit for controlling the OLED in dependence on the resistance;
- Figure 8 shows a second example of electrode layout used in the example of Figures 3 and 4;
- Figure 9 shows a fourth example in which an inductor coil layer is used to encode electrical characteristic information about the OLED device.

### DETAILED DESCRIPTION OF THE EMBODIMENTS

The invention provides an OLED device according to claim 1.

The encoding layer can encode electrical information such as driving voltage and/or current and dimming levels. These may correspond directly to the area of the OLED device, so that the encoding layer naturally encodes this information by making it scale with the size of the OLED component. However, other information such as size, shape, colour point, single or tuneable OLED etc. can also be encoded. A PCB can be used to interface between the device and a driver. The PCB may already be a required part of the device design, for example a PCB may already be present as part of an OLED device design for improved current distribution on substrates with limited conductivity.

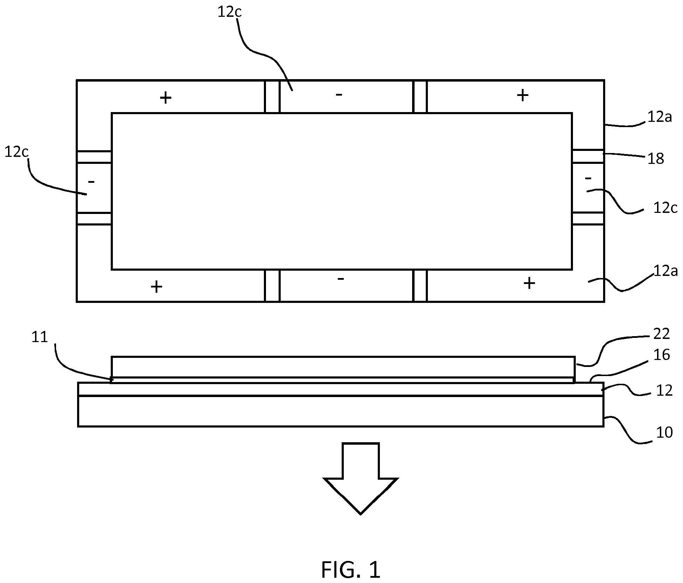

Figure 1 shows in simplified schematic form an example of OLED device to which the invention is applied.

The OLED comprises a substrate 10 and a transparent conductive layer 12 over the substrate (transparent because this example is a bottom emitting structure). An encapsulated OLED structure is provided over the contact layer 12, comprising OLED layers 11 which are much thinner than the substrate, and an encapsulation 22. An outer ledge 16 of the contact layer 12 extends laterally beyond an outer edge of the encapsulated OLED structure.

The OLED structure has multiple anode and cathode contacts, and these connect to different contact regions of the contact layer 12 in the ledge area to form contact areas for the cathode and anode layers of the OLED structure. The plan view in Figure 1 shows four cathode contact regions 12c, one at the centre of each edge of the OLED structure, and four anode contact regions 12a at the four corners. Separation gaps 18 are provided.

Figure 1 shows a bottom emitting OLED structure, with light emitted through the substrate. For this reason, the contact layer 12 is transparent, and can for example comprise ITO, ZnO:AI, or other transparent conductors, typically materials from the group of transparent conductive oxides (TCOs). New technologies such as carbon nano-tubes or layer sequences can also be used. The relatively high resistance of some transparent conductors, such as ITO, means that electrical connections with better conductivity are desired to distribute the current along the contact ledges to the anode contact regions and the cathode contact regions to reduce voltage drop and hence improve on homogeneity.

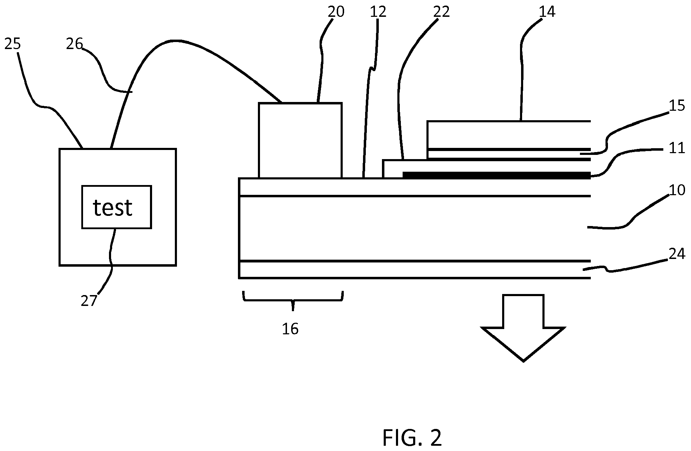

For this purpose, a PCB in a frame shape can be mounted over the contact ledge 16. The structure is shown in more detail in Figure 2, with the PCB 20 mounted on the contact ledge 16.

Other approaches for forming contacts and to improve lateral current injection are available such as a bonded anisotropic conductive film ("ACF") or glued metal wires. These present a simpler and cheaper alternative to a PCB.

The structure of the OLED device can be conventional. A typical OLED according to the state of the art consists of active organic layers, a cathode, an anode, and a substrate. The active organic layers consist of a hole transport layer and a light emitting polymer for a polymer-based OLED (known as p-OLEDs). The small-molecule version of an OLED (known as sm-OLEDs) consists of some additional layers: hole injecting, emitting, hole blocking and electron transport layers. Furthermore functional layers like CGL (charge generation layers) can also be included. The manufacture of the OLED can be based on printed or evaporated OLEDs but also other/future techniques like liquid processing can be used.

In the context of this invention it is sufficient to reduce the complex internal structure of a real OLED device, shown simply as layer 11 in Figure 1, to a simplified three layer arrangement of the anode layer, the active emission layer and the cathode layer.

Furthermore, additional encapsulation thin film layers 22 are deposited on this stack, as mentioned above, to protect the organic material from e.g. water and oxygen to prevent early degradation of the OLED materials. This protection is called thin film encapsulation (TFE), because the layer or layers have a thickness of about 100nm. The thin film encapsulation layer can consist of inorganic oxides, such as Al₂O₃ or alternating layers of Al₂O₃ and ZrO₂, called a nanolaminate structure, deposited for example by atomic layer deposition (ALD).

Also other materials such as other oxides or nitrides can be used. These encapsulation thin film layers are dielectric and insulating.

The encapsulation layers protect the cathode side. The anode side is for example protected by the carrier material directly in the case of a glass substrate or via further layers in the case of a plastic substrate.

The OLED active layers are deposited on a substrate which may be coated with, for instance, indium tin oxide (ITO), thereby forming an ITO layer typically of about 150 nm to function as a hole-injecting electrode. The cathode applied on top of the organic layers which provides electron injection is of the order of 100 nm thick.

The OLED layer stack 11 is provided between the anode layer 12 and the encapsulation 22.

The contact layer 12 functions as the anode, and the layer stack 11 then comprises the organic layers and a top cathode metal. Alternatively, the layer stack may include the anode layer (in addition to the contact layer).

The substrate 10 is the substrate for the OLED stack. The substrate can be glass for rigid devices or it may be plastic (typically with a barrier layer) for example for flexible devices. Very thin glass substrates can also enable a degree of bending.

In the example shown, the encapsulation 22 overlaps the edge of the OLED layers 11 but terminates before the contact ledge 16, whereas the contact layer 12 extends fully to the outer edge so that the PCB 20 can connect to the contact regions.

An alternative is to extend the encapsulation layers (in case of thin film encapsulation rather than glass encapsulation) to the edge of the device which is then locally removed in regions where contact with the underlying electrodes is desired.

The cathode layer can be sufficiently conductive to provide homogeneous devices of relevant dimensions. However, a metal foil 14 may also be provided over the top for heat distribution/dissipation and mechanical protection of the thin film encapsulation. An adhesive layer 15 bonds the metal foil (if present) to the encapsulation 22.

As one example only, the ledge width can be of the order of 3mm, the overall device thickness can be approximately 1mm to 3mm based on a rigid glass substrate thickness typically in the range 0.7 to 2.0mm. Thinner devices may be formed using bendable glass substrates or flexible plastics substrates. The overall panel size can have typical linear dimensions in the range 5cm to 30cm, although larger or smaller devices are possible.

The PCB 20 is glued to the OLED and hence is part of the module which is generally sold separately from the driver electronics. The PCB is not removable from the device substrate. The driver electronics is then wired to the PCB.

Figure 2 shows schematically the driver 25 coupled to the PCB 20 by a flat cable 26, although a plug and socket can be used. This interconnection between the LED-PCB module and the driver can be located at a different place to the OLED unit itself, for example set aside in a luminaire housing or in a piece of furniture.

The driver 25 includes testing circuitry 27, described further below. The combination of driver 25 and OLED module may change throughout the lifetime of an OLED, whereas the combination of an OLED and its associated PCB will not.

The printed circuit board 20 has a bottom metallisation layer which includes pads for connecting to the anode and cathode regions 12a, 12c. Conductive glue can be used to bond these pads to the cathode and anode contact regions of the connection layer. The PCB has a second metallisation layer for providing interconnects between the anode regions and between the cathode regions. It might comprise even more layers in case more complex contacting structures are used, for example as may be required for colour-tuneable devices. Thus, the PCB comprises at least two conducting layers. Vias are used to connect between the layers at desired locations.

The second layer can be at the top or within the PCB structure.

In one example, the PCB has a frame shape mounted over the outer ledge 16. In addition to interconnecting the cathode and anode regions, it provides the external contacts for electrical connection of the driver to the OLED as shown in Figure 2. Other shapes of the PCB can be used, or a number of smaller more local PCBs can be used to contact the cathode/anode layers if the device design allows for it.

Figure 2 also shows a light diffusing foil 24 at the light output face of the OLED package. This may or may not be desired depending on the lighting application.

The invention makes use of an encoding layer formed on top the stack of layers which define the OLED. The area of the encoding layer encodes information concerning the electrical characteristics of the OLED component. The area is not measured directly but is measured based on an electrical parameter which itself depends on area. Two examples given below in more detail are the resistance of a resistive layer, or the inductance of a coil.

The encoding layer forms an electrical component, such as a resistor and this component makes use of existing layers within the structure of the OLED.

Silicon nitride (SiN), "organic coating for planarization" (OCP) and Aluminium (Al) are typical materials use in the manufacture of OLEDs. They are coated quite homogeneously on the surface of the OLED. Structuring via masks, etching, and photolithography can be applied.

A first implementation of the invention is based on the addition of an encoding layer with limited conductivity, preferably between highly conductive layers such as aluminium, over the area of the OLED. By "area" of an OLED is meant the light outputting area, which corresponds to the area of an electroluminescent material layer. In this first implementation, the encoding layer is formed as a resistive layer.

By making the area of such a resistive layer proportional to the light emitting area of the OLED, it becomes proportional to the nominal drive current of the OLED.

Conductive materials are characterized by a sheet resistance. Applying a layer of homogeneous thickness between highly conductive electrodes will result in a resistance which is inversely proportional to the area. Thus, the larger the OLED, the lower the resistance of the resistive layer. This provides automatic coding of the desired drive current simply by scaling the same device design. No extra steps of adjusting the resistive layer material or structuring the shape or pattern of the resistive layer are required. This also means that a set of devices of different sizes can be made to the same but scaled design. The scaling automatically alters the resistance value as a result of the change in layer area. The scaling does not alter the layer thicknesses, so it is in two dimensions.

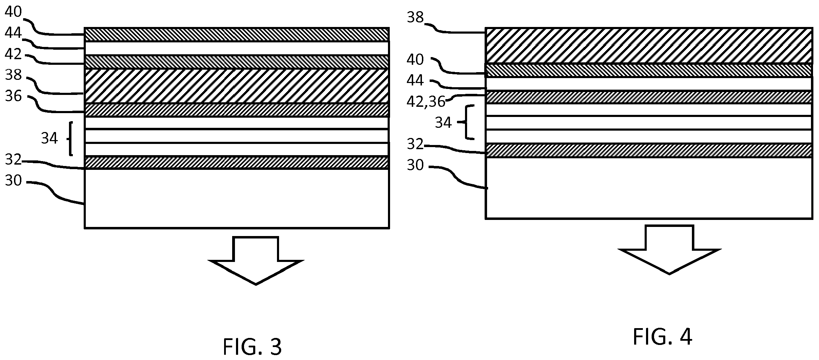

Figure 3 shows a first example of how to incorporate an additional resistive layer into the stack of layers of an OLED component.

The device comprises a substrate 30, transparent anode 32 such as ITO, and a stack 34 of electroluminescent layers for current conduction and light generation. A cathode layer 36 such as aluminium is over the electroluminescent layer stack and there is an encapsulation layer 38. In the example of Figure 3, there is a first and second sensing electrode layer 40,42 with the resistive layer 44 between. This three layer structure is provided over the encapsulation layer 38.

Figure 4 shows a second example of how to incorporate an additional resistive layer into the stack of layers of an OLED component. The same layers are given the same references as in Figure 3 . In this case, the sensing electrode layers 40,42 and resistive layer 44 are beneath the encapsulation layer 38. This means the cathode layer 36 can be the same layer of aluminium as the second electrode layer 42.

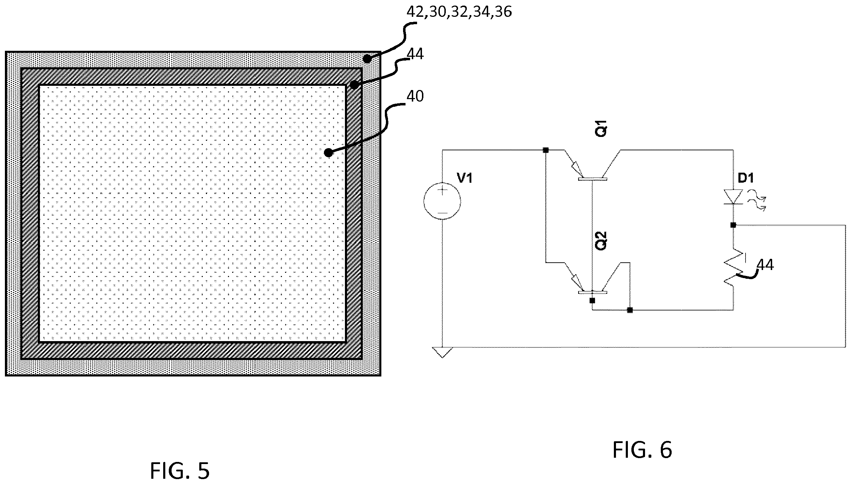

Figure 5 shows a plan view. The area of the resistive layer 44 is essentially proportional to the device size. The electrode layers 40,42 are shown with slightly different sizes to give edge regions to which electrical connections can be made.

The resistance of the resistive layer 44 can be measured for example by applying a test voltage between the electrode layers 40,42 and measuring the resulting current. This enables detection of the OLED area and hence adjustment of the driver current in a very simple manner. Current mirror technique can be applied for this.

The encapsulation layer 38 can be a thin film encapsulation, but it may equally be a glass layer for a glass encapsulated OLED.

The current density arising in the resistive layer can be controlled by suitable selection of the voltage level and/or by selecting a suitable ratio between the size of the active area and the size of the resistive layer.

Figure 6 shows a monitoring and driving circuit, comprising a voltage source V1 and a current source circuit comprising first and second bipolar transistors Q1, Q2. The transistors have coupled emitter and base contacts. The current flowing through the resistive layer 44 depends on the resistance, and this current is mirrored (with suitable scaling) to flow through the LED D1. The scaling depends on the emitter area of Q1 and Q2.

In this way, the resistive layer automatically controls the current delivered to the OLED D1.

Alternatively, the value of the desired OLED forward current may be evaluated by injecting a current into the resistive layer, measuring the voltage across the resistive layer, and calculating the conductivity. This task may preferably be performed by a microcontroller. The driver can then be controlled accordingly.

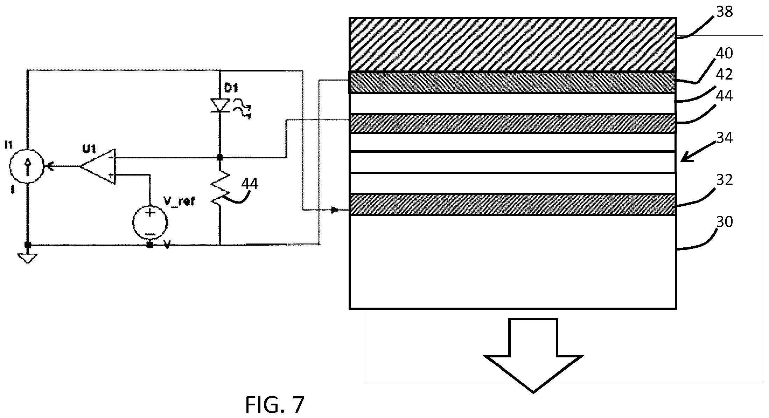

If a material with a low resistivity is used, or a thin layer is formed, a low resistance value will result. This means the resistor can be in series with the OLED and pass the OLED current without influencing the circuit function. A different monitoring and driving circuit may then be used as shown in Figure 7 .

An operational amplifier U1 has its non-inverting input connected to a reference voltage V_ref, and the resistive layer is connected between its inverting and non-inverting inputs. The amplifier controls a current source which drives a current through the OLED D1. This current also passes through the resistor layer, so that the OLED and resistive layer are in series. The resistive layer thus function as a measurement device for measuring the OLED current, and the amplifier circuit implements feedback control based on the current being greater or less than the current corresponding to the reference voltage. For different values of resistance, the constant reference voltage will correspond to a different driver current. Thus the adjustment of the driving conditions is again automatically implemented in dependence on the area of the resistive layer.

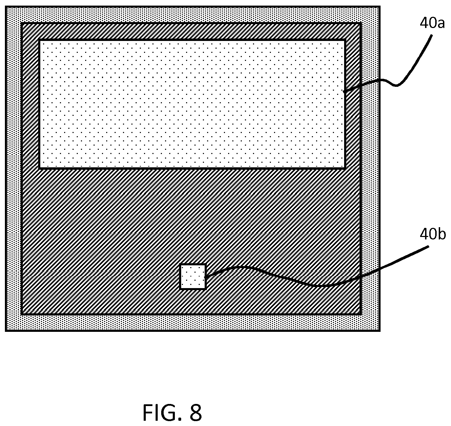

Resistive layers are typically characterized by good homogeneity across the area but low initial accuracy. Known solutions to this problem include laser trimming. However, trimming the resistive layer would be a tedious task, because it has a large area. To improve the accuracy of the active OLED area information coded in the resistive layer, a calibration area with fixed area may be applied as shown in Figure 8.

In the example shown in Figure 8, the top electrode is patterned to form a readout area 40a and a calibration area 40b.

As an example. 1cm² of the OLED area may be used as a reference resistor 40b, and a fixed portion 40a (90% or 50% for example) of the remaining area is used to represent the active OLED area and hence encode the required driver current.

In this case, instead of using the absolute value of the resistive layer as an indication for the forward current, the ratio between the resistance values for the areas 40a and 40b is used.

For example, if;
- R_40b = 15000 Ohm; and
- R_40a = 300 Ohm,

Then the relative area is R_40b/R_40a = 50. If the area of 40b = 1cm² and the relative coverage of the area 40a = 0.5 (50%) then the active area of the OLED will be 100 cm².

For a predefined current density, the nominal drive current of the driver can be calculated. Extra factors for dimming, ageing compensation, and other factors can be applied in the calculation. Varying the size of the calibration area or the relative read out electrode area can be used for setting different nominal current densities.

A second implementation not forming part of the invention is based on the addition of an encoding layer which forms an inductor. As in the examples above, the inductance scales with size so that the same design can be scaled with the encoded information automatically scaling.

As explained with reference to Figure 1, multiple electrode contacts are provided for each polarity area spread around the light emitting area. With electrode contacts spread along the outer rim of the OLED area, a conductor for combining all these signals is placed around the light emitting area, in the form of an attached PCB.

An inductor can be formed making use of this PCB. In this way the powering signal to the anode or cathode or both is routed around the PCB before being supplied to the OLED electrodes. This forms an inductor. The effect of this inductor can be detected by the driver in order to control the nominal forward current of the OLED.

By providing one or more conductor loops around the PCB 20 (see Figure 2) the signal is routed around the active area on the OLED, such that the loop area is proportional to the size of the OLED. No extra wiring components are required, and use is simply made of the PCB used for contacting the OLED spaced electrodes.

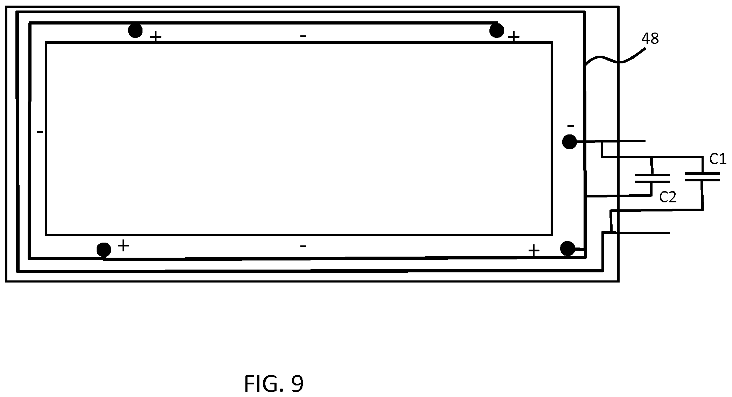

Figure 9 shows the PCB of Figure 1 in which a conductor track 48 forms a loop before making connection to the anode regions (shown as "+") using contact pads One or more loops may be formed, and they may be in the anode line and/or the cathode line.

In Figure 9, all of the cathode connections are not shown; only one cathode connection pad is shown. As explained below, stabilizing capacitors may be used, and Figure 9 shows a first, recommended stabilizing capacitor C1 between the cathode line and the outer end of the anode loop and a second, optional, stabilizing capacitor C2 between the cathode line and the inner end of the anode loop.

The loop or loops function as an inductor. Since the cabling between the driver and the OLED also has a parasitic inductance, it would be difficult to separate one from the other. However, by placing the first stabilizing capacitor C1 at the connection point between the cabling and the loop, unwanted effects by the cabling can be minimized.

The end of the loop connects to at least one contact of the OLED. The OLED itself has a capacitance. For optimal determination of the size of the OLED, the capacitance of the OLED should be larger than the first stabilization capacitor C1. If this is already the case, e.g. due to the stack design and the size of the OLED, no further capacitors are required for fundamental operation of the detection circuitry. However. in order to provide decoupling from the tolerances, non-linearity and operation point dependency of the OLED capacitance, a further, larger capacitor C2 may be used.

The second capacitor C2 is connected in parallel with the anode-cathodes structure of the OLED. A single capacitor or multiple capacitors can be used. In the latter case, the multiple capacitors are preferably geometrically aligned with the multiple anode and/or cathode electrodes of the OLED.

In the arrangement of Figure 9, there are various impedances which influence the circuit operation. There is a cabling inductance, the first and second stabilization capacitances, the inductance of the winding around the OLED and the OLED with its parallel capacitor. The stabilizing capacitors are fixed capacitors, so it is not required to have different values for these components available.

The inductance can be measured using a resonant circuit. In combination with the stabilizing capacitors, the inductor forms a resonance tank. The resonance frequency of that tank is defined by the size of the area enclosed by the loop. Thus, measuring the inductance and hence the area of the OLED (i.e. in order to determine the forward current) can be via a measurement of the resonance frequency. The effect of the cable (distance of conductors, length) is minimized in at least one frequency range by the first stabilization capacitor C1. Hence, the inductor on the OLED can be detected reliably, independently of the cabling between driver and OLED.

The driver will, in most cases, be a switch mode power supply. Normally, the high frequency switching artefacts (typically in the kHz range) are filtered out, so that they are not present on the output signals with too high amplitude. However, a certain level of high frequency signal can be accepted on the output signals of the driver. So, in one mode, the driver will operate at least one of its switching elements with a frequency, which directly or via its harmonics, can excite the resonance tank built into the OLED. This resonance tank will act as a loading for the output signal of the driver. By measuring the output signal of the driver, the loading can be determined.

The driver may be controlled to excite different possible resonance frequencies and capture the corresponding loading. Based on these measurements, the resonance frequency can be determined.

The driver may have two modes: a measuring mode and a forward current driving mode. Alternatively, the measuring may be based on small variations of the forward current, such that continuous tracking is possible. In a further example, the inductance may be influenced during operation by effects of the OLED or the environment. For example, during operation, the OLED may heat up, changing the magnetic properties in at least one volume interacting with the magnetic field of the routed signal. If these changes can be characterized, they can also be used to provide a measurement of inductance.

The invention is of particular interest for general lighting applications and OLED based luminaires. For example the encoded information can relate to a light output panel with a single output area which has controllable brightness and/or colour.

## Claims

1. An OLED device, comprising:
a substrate (10, 30);
a stack of layers (11) on top of the substrate (10, 30) defining an OLED component with an active light outputting area comprising an electroluminescent layer stack (34) arranged between an anode layer (32) and a cathode layer (36), the OLED component having electrical characteristics; and
an encoding structure, provided over the OLED component, comprising a three layer structure with a resistive layer (44) and first and second sensing electrode layers (40, 42) provided above and beneath the resistive layer (44), wherein the first and a second sensing electrode layers (40, 42) are provided with contact regions to enable probing of the resistance of the resistive layer (44), wherein the resistance of the area of the resistive layer (44) in the encoding structure encodes information concerning the electrical characteristics of the OLED component.

2. The OLED device as claimed in claim 1, wherein the resistive layer (44) has an area which is a predetermined ratio of the active light outputting area.

3. The OLED device as claimed in claim 2, wherein the resistive layer (44) comprises a reference portion and a readout portion, wherein the resistive layer (44) is a continuous layer and the first sensing electrode layer (40) on top of the resistive layer (44) is patterned to form a readout area (40a) and a reference area (40b) defining the reference portion and readout portion of the resistive layer (44).

4. The OLED device as claimed in claim 1 or 2, wherein the resistive layer (44) and the first and second sensing electrodes (40, 42) have an area equal to the active light outputting area of the OLED component.

5. The OLED device as claimed in any preceding claim, wherein an encapsulation layer (38) covers the cathode layer (36) and the encoding structure is arranged on top of the encapsulation layer (38).

6. The OLED device as claimed in any of claims 1 to 4, wherein the cathode layer (36) of the OLED component (11) is the same layer as the second sensing electrode layer (42) of the encoding structure.

7. The OLED device as claimed in claim 1, wherein the resistance of the encoding layer encodes the electrical characteristics of the OLED component concerning a desired driving current and/or voltage and/or a required dimming level.

8. An OLED lighting apparatus comprising:
an OLED module comprising:
an OLED device as claimed in any preceding claim,
a PCB (20) connected to the contact regions of the OLED component via PCB contact pads; and
a driver (25) comprising a connection part (26) configured to interface with the PCB (20), wherein the driver (25) comprises a testing circuitry (27) adapted to determine the resistance of the resistive layer, wherein
the driver (25) is adapted to drive the OLED module in dependence on the determined resistance.

9. An OLED lighting apparatus as claimed in claim 8, wherein the driver (25) is adapted to drive the OLED device in dependence on the information concerning the electrical characteristic of the OLED component as determined by the testing circuitry (27).

10. A method of driving an OLED light apparatus according to claim 8 or 9, the method comprising:
- measuring the resistance of the resistive layer of the encoding structure; and
- driving the OLED device in dependence on the measured resistance using the driver.

11. The method of driving an OLED device as claimed in claim 10, wherein the resistance of the resistive layer (44) is measured by applying a test voltage between the first and a second sensing electrode layers (40, 42) and measuring the resulting current or by injecting a current into the resistive layer and measuring the voltage across the first and a second sensing electrode layers (40, 42).

## Patentansprüche

1. OLED-Vorrichtung, umfassend:
ein Substrat (10, 30);
einen Schichtstapel (11) auf der Oberseite des Substrats (10, 30), der eine OLED-Komponente mit einem aktiven Lichtausgabebereich definiert, der einen elektrolumineszenten Schichtstapel (34) umfasst, der zwischen einer Anodenschicht (32) und einer Kathodenschicht (36) angeordnet ist, wobei die OLED-Komponente elektrische Eigenschaften aufweist; und
eine Kodierstruktur, die über der OLED-Komponente vorgesehen ist und eine dreischichtige Struktur mit einer Widerstandsschicht (44) und einer ersten und einer zweiten Sensorelektrodenschicht (40, 42) umfasst, die über und unter der Widerstandsschicht (44) vorgesehen sind, wobei die erste und die zweite Sensorelektrodenschicht (40, 42) mit Kontaktbereichen versehen sind, um ein Prüfen des Widerstands der Widerstandsschicht (44) zu ermöglichen, wobei der Widerstand des Bereichs der Widerstandsschicht (44) in der Kodierstruktur Information bezüglich der elektrischen Eigenschaften der OLED-Komponente kodiert.

2. OLED-Vorrichtung nach Anspruch 1, wobei die Widerstandsschicht (44) eine Fläche aufweist, die ein vorbestimmtes Verhältnis zum aktiven Lichtausgabebereich ist.

3. OLED-Vorrichtung nach Anspruch 2, wobei die Widerstandsschicht (44) einen Referenzabschnitt und einen Ausleseabschnitt umfasst, wobei die Widerstandsschicht (44) eine kontinuierliche Schicht ist und die erste Sensorelektrodenschicht (40) auf der Widerstandsschicht (44) strukturiert ist, um einen Auslesebereich (40a) und einen Referenzbereich (40b) zu bilden, die den Referenzabschnitt und den Ausleseabschnitt der Widerstandsschicht (44) definieren.

4. OLED-Vorrichtung nach Anspruch 1 oder 2, wobei die Widerstandsschicht (44) und die erste und zweite Sensorelektrode (40, 42) eine Fläche aufweisen, die gleich dem aktiven Lichtausgabebereich der OLED-Komponente ist.

5. OLED-Vorrichtung nach einem der vorhergehenden Ansprüche, wobei eine Verkapselungsschicht (38) die Kathodenschicht (36) bedeckt und die Kodierstruktur auf der Verkapselungsschicht (38) angeordnet ist.

6. OLED-Vorrichtung nach einem der Ansprüche 1 bis 4, wobei die Kathodenschicht (36) der OLED-Komponente (11) dieselbe Schicht ist wie die zweite Sensorelektrodenschicht (42) der Kodierstruktur.

7. OLED-Vorrichtung nach Anspruch 1, wobei der Widerstand der Kodierschicht die elektrischen Eigenschaften der OLED-Komponente bezüglich eines gewünschten Treiberstroms und/oder einer gewünschten Spannung und/oder eines erforderlichen Dimmpegels kodiert.

8. OLED-Beleuchtungsvorrichtung, die umfasst:
ein OLED-Modul, bestehend aus:
eine OLED-Vorrichtung nach einem der vorhergehenden Ansprüche,
eine Leiterplatte (20), die mit den Kontaktbereichen der OLED-Komponente über Leiterplattenkontaktflächen verbunden ist; und
einen Treiber (25), der ein Verbindungsteil (26) umfasst, das so konfiguriert ist, dass es eine Schnittstelle mit der Leiterplatte (20) bildet, wobei der Treiber (25) eine Prüfschaltung (27) umfasst, die so angepasst ist, dass sie den Widerstand der Widerstandsschicht bestimmt, wobei
der Treiber (25) so angepasst ist, dass er das OLED-Modul in Abhängigkeit von dem ermittelten Widerstand ansteuert.

9. OLED-Beleuchtungsvorrichtung nach Anspruch 8, wobei der Treiber (25) dazu angepasst ist, die OLED-Vorrichtung in Abhängigkeit von der Information bezüglich der elektrischen Eigenschaft der OLED-Komponente, wie sie von der Prüfschaltung (27) bestimmt wird, anzusteuern.

10. Verfahren zum Ansteuern einer OLED-Beleuchtungsvorrichtung nach Anspruch 8 oder 9, wobei das Verfahren umfasst:
- Messen des Widerstands der Widerstandsschicht der Kodierstruktur; und
- Ansteuerung der OLED-Vorrichtung in Abhängigkeit vom gemessenen Widerstand unter Verwendung des Treibers.

11. Verfahren zum Ansteuern einer OLED-Vorrichtung wie in Anspruch 10 beansprucht, wobei der Widerstand der Widerstandsschicht (44) durch Anlegen einer Prüfspannung zwischen der ersten und einer zweiten Sensorelektrodenschicht (40, 42) und Messen des resultierenden Stroms oder durch Injizieren eines Stroms in die Widerstandsschicht und Messen der Spannung über der ersten und einer zweiten Sensorelektrodenschicht (40, 42) gemessen wird.

## Revendications

1. Dispositif à DELO, comprenant :
un substrat (10, 30) ;
un empilement de couches (11) sur la face supérieure du substrat (10, 30) délimitant un composant DELO avec une zone de sortie de lumière active comprenant un empilement de couches électroluminescentes (34) disposées entre une couche d'anode (32) et une couche de cathode (36), le composant DELO ayant des caractéristiques électriques ; et
une structure de codage, disposée sur le composant DELO, comprenant une structure à trois couches avec une couche résistive (44) et une première et une seconde couche d'électrode de détection (40, 42) disposées au-dessus et en dessous de la couche résistive (44), la première et une seconde couche d'électrode de détection (40, 42) étant dotées de régions de contact pour permettre l'examen de la résistance de la couche résistive (44), la résistance de la zone de la couche résistive (44) dans la structure de codage codant des informations concernant les caractéristiques électriques du composant DELO.

2. Dispositif à DELO selon la revendication 1, la couche résistive (44) ayant une zone qui est un rapport prédéfini de la zone de sortie de lumière active.

3. Dispositif à DELO selon la revendication 2, la couche résistive (44) comprenant une partie de référence et une partie de lecture, la couche résistive (44) étant une couche continue et la première couche d'électrode de détection (40) sur la face supérieure de la couche résistive (44) présentant des motifs pour former une zone de lecture (40a) et une zone de référence (40b) délimitant la partie de référence et la partie de lecture de la couche résistive (44).

4. Dispositif à DELO selon la revendication 1 ou la revendication 2, la couche résistive (44) et les première et seconde électrodes de détection (40, 42) ayant une zone égale à la zone de sortie de lumière active du composant DELO.

5. Dispositif à DELO selon l'une quelconque revendication précédente, une couche d'encapsulation (38) recouvrant la couche de cathode (36) et la structure de codage étant disposée sur la face supérieure de la couche d'encapsulation (38).

6. Dispositif à DELO selon l'une quelconque des revendications 1 à 4, la couche de cathode (36) du composant DELO (11) étant la même couche que la seconde couche d'électrode de détection (42) de la structure de codage.

7. Dispositif à DELO selon la revendication 1, la résistance de la couche de codage codant les caractéristiques électriques du composant DELO concernant un courant de commande souhaité et/ou une tension et/ou un niveau de gradation de l'intensité lumineuse exigé.

8. Dispositif d'éclairage à DELO comprenant :
un module DELO comprenant :
un dispositif DELO selon l'une quelconque revendication précédente,
une carte de circuit imprimé (20) connectée aux régions de contact du composant DELO par l'intermédiaire des plots de connexion ; et
un pilote (25) comprenant une partie de connexion (26) conçue pour faire l'interface avec la carte de circuit imprimé (20), le pilote (25) comprenant une circuiterie d'essai (27) conçue pour déterminer la résistance de la couche résistive,
le pilote (25) étant conçu pour commander le module DELO en fonction de la résistance déterminée.

9. Dispositif d'éclairage à DELO selon la revendication 8, le pilote (25) étant conçu pour commander le dispositif DELO en fonction des informations concernant la caractéristique électrique du composant DELO déterminée par la circuiterie d'essai (27).

10. Procédé de commande d'un dispositif d'éclairage à DELO selon la revendication 8 ou la revendication 9, le procédé consistant à :
- mesurer la résistance de la couche résistive de la structure de codage ; et
- commander le dispositif DELO en fonction de la résistance mesurée à l'aide du pilote.

11. Procédé de commande d'un dispositif d'éclairage à DELO selon la revendication 10, la résistance de la couche résistive (44) étant mesurée par application d'une tension d'essai entre les première et seconde couches d'électrode de détection (40, 42) et par mesure du courant obtenu ou par injection d'un courant dans la couche résistive et par mesure de la tension dans les première et seconde couches d'électrode de détection (40, 42).
